# EUROPEAN PATENT APPLICATION

(11) **EP 2 070 965 A1**
(43) Date of publication of application: **17.06.2009**
(21) Application number: 07807097.6
(22) Date of filing: 05.09.2007
(51) Int. Cl.: C08G 61/12, C09K 11/06, H01L 29/786, H01L 51/05, H01L 51/30, H01L 51/50

(54) **POLYMER COMPOUND AND POLYMER LIGHT-EMITTING DEVICE**

(30) Priority: 13.09.2006 JP 2006247803
(71) Applicant: Sumitomo Chemical Company, Limited, Tokyo 104-8260 (JP)
(72) Inventor: NAKATANI, Tomoya, Tsukuba-shi Ibaraki 305-0821 (JP); FUKUSHIMA, Daisuke, Tsukuba-shi Ibaraki 305-0045 (JP)
(74) Representative: Duckworth, Timothy John
(86) International application number: PCT/JP2007/067688
(87) International publication number: WO 2008/032720

(57) **Abstract**

A polymer compound comprising a repeating unit of the following formula (I) and a repeating unit of the following formula (II): 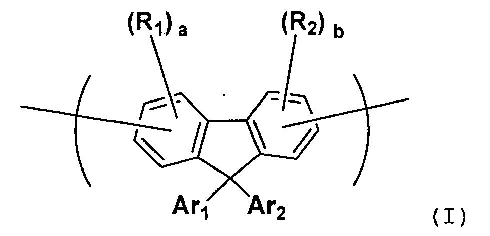 [wherein, Ar₁ and Ar₂ represent an aryl group or monovalent heterocyclic group, R₁ and R₂ represent an alkyl group, alkoxy group or the like, and a and b represent an integer selected from 0 to 3.] 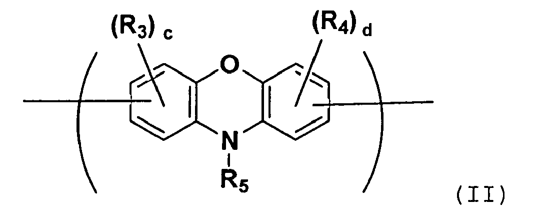 [wherein, R₅ represents an alkyl group, R₃ and R₄ represent an alkyl group, alkoxy group or the like, and c and d represent each independently an integer selected from 0 to 3].

## Description

### Technical Field

The present invention relates to a polymer compound and a polymer light emitting device using the same.

### Background Art

Light emitting materials and charge transporting materials of high molecular weight are useful as materials used in an organic layer of devices such as light emitting devices and the like, thus, have undergone various investigations, and reported as examples thereof are polymer compounds which are copolymers consisting of a fluorenediyl group having two alkyl groups at 9-position, and a phenoxazinediyl group having an alkyl group on N (for example, Macromolecules; 2005, 38, 7983-7991).

The above-described polymer compounds reported, however, have not yet necessarily sufficient heat resistance and light emission efficiency when used as a light emitting material for light emitting devices.

### DISCLOSURE OF THE INVENTION

An object of the present invention is to provide a polymer compound having high heat resistance or being capable of giving a device having high light emission efficiency.

That is, the present invention provides a polymer compound comprising a repeating unit of the following formula (I) and a repeating unit of the following formula (II): 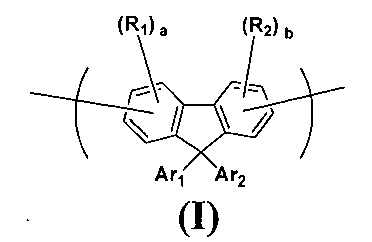 [in the above-described formula (I), Ar₁ and Ar₂ represent each independently an aryl group or monovalent heterocyclic group, R₁ and R₂ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and a and b represent each independently an integer selected from 0 to 3. When there exist a plurality of R₁s and R₂s respectively, they may be the same or different.] 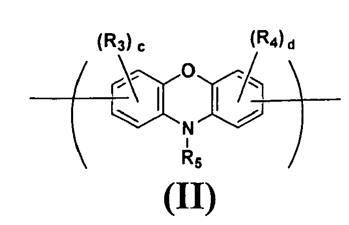 [in the above-described formula (II), R₅ represents an alkyl group, R₃ and R₄ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and c and d represent each independently an integer selected from 0 to 3. When there exist a plurality of R₃s and R₄s respectively, they may be the same or different.].

### MODES FOR CARRYING OUT THE INVENTION

The polymer compound of the present invention contains a repeating unit of the above-described formula (I).

Here, the aryl group is an atomic group obtained by removing one hydrogen atom from an aromatic hydrocarbon, and includes those having a condensed ring, and also those having independent two or more benzene rings or condensed rings connected directly or via a group such as vinylene and the like. The aryl group has a carbon number of usually about from 6 to 60, preferably 6 to 48. The carbon number of the aryl group does not include the carbon number of substituents. Specific examples thereof include a phenyl group, C₁ to C₁₂ alkoxyphenyl groups (C₁ to C₁₂ means a carbon number of 1 to 12, being applicable also in the following descriptions.), C₁ to C₁₂ alkylphenyl groups, 1-naphthyl group, 2-naphthyl group, 1-anthracenyl group, 2-anthracenyl group, 9-anthracenyl group, pentafluorophenyl group and the like, and preferable are C₁ to C₁₂ alkoxyphenyl groups and C₁ to C₁₂ alkylphenyl groups. Specific examples of the C₁ to C₁₂ alkoxyphenyl group include a methoxyphenyl group, ethoxyphenyl group, propyloxyphenyl group, isopropyloxyphenyl group, butoxyphenyl group, isobutoxyphenyl group, t-butoxyphenyl group, pentyloxyphenyl group, hexyloxyphenyl group, cyclohexyloxyphenyl group, heptyloxyphenyl group, octyloxyphenyl group, 2-ethylhexyloxyphenyl group, nonyloxyphenyl group, decyloxyphenyl group, 3,7-dimethyloctyloxyphenyl group, lauryloxyphenyl group and the like.

Specific examples of the C₁ to C₁₂ alkylphenyl group include a methylphenyl group, ethylphenyl group, dimethylphenyl group, propylphenyl group, mesityl group, methylethylphenyl group, isopropylphenyl group, butylphenyl group, isobutylphenyl group, t-butylphenyl group, pentylphenyl group, isoamylphenyl group, hexylphenyl group, heptylphenyl group, octylphenyl group, nonylphenyl group, decylphenyl group, dodecylphenyl group and the like.

The monovalent heterocyclic group refers to an atomic group remaining after removing one hydrogen atom from a heterocyclic compound, and the carbon thereof is usually about from 4 to 60, preferably 4 to 20. Among monovalent heterocyclic groups, monovalent aromatic heterocyclic groups are preferable. The carbon number of the heterocyclic group does not include the carbon number of substituents. Here, the heterocyclic compound refers to organic compounds having a cyclic structure in which elements constituting the ring include not only a carbon atom, but also a hetero atom such as oxygen, sulfur, nitrogen, phosphorus, boron and the like contained in the ring. Specific examples thereof include a thienyl group, C₁ to C₁₂ alkylthienyl groups, pyrrolyl group, furyl group, pyridyl group, C₁ to C₁₂ alkylpyridyl groups, piperidyl group, quinolyl group, isoquinolyl group and the like, and preferable are a thienyl group, C₁ to C₁₂ alkylthienyl groups, pyridyl group and C₁ to C₁₂ alkylpyridyl groups.

In R₁, R₂ in the above-described formula (I), the alkyl group may be any of linear, branched or cyclic, and optionally has a substituent. The carbon number thereof is usually about from 1 to 20, and specific examples thereof include a methyl group, ethyl group, propyl group, isopropyl group, butyl group, isobutyl group, t-butyl group, pentyl group, hexyl group, cyclohexyl group, heptyl group, octyl group, 2-ethylhexyl group, nonyl group, decyl group, 3,7-dimethyloctyl group, lauryl group, trifluoromethyl group, pentafluoroethyl group, perfluorobutyl group, perfluorohexyl group, perfluorooctyl group and the like.

The alkoxy group may be any of linear, branched or cyclic, and optionally has a substituent. The carbon number thereof is usually about from 1 to 20, and specific examples thereof include a methoxy group, ethoxy group, propyloxy group, isopropyloxy group, butoxy group, isobutoxy group, t-butoxy group, pentyloxy group, hexyloxy group, cyclohexyloxy group, heptyloxy group, octyloxy group, 2-ethylhexyloxy group, nonyloxy group, decyloxy group, 3,7-dimethyloctyloxy group, lauryloxy group, trifluoromethoxy group, pentafluoroethoxy group, perfluorobutoxy group, perfluorohexyloxy group, perfluorooctyloxy group, methoxymethyloxy group, 2-methoxyethyloxy group and the like.

The alkylthio group may be any of linear, branched or cyclic, and optionally has a substituent. The carbon number thereof is usually about from 1 to 20, and specific examples thereof include a methylthio group, ethylthio group, propylthio group, isopropylthio group, butylthio group, isobutylthio group, t-butylthio group, pentylthio group, hexylthio group, cyclohexylthio group, heptylthio group, octylthio group, 2-ethylhexylthio group, nonylthio group, decylthio group, 3,7-dimethyloctylthio group, laurylthio group, trifluoromethylthio group and the like.

The aryloxy group has a carbon number of usually about from 6 to 60, preferably 7 to 48, and specific examples thereof include a phenoxy group, C₁ to C₁₂ alkoxyphenoxy groups, C₁ to C₁₂ alkylphenoxy groups, 1-naphthyloxy group, 2-naphthyloxy group, pentafluorophenyloxy group and the like, and preferable are C₁ to C₁₂ alkoxyphenoxy groups and C₁ to C₁₂ alkylphenoxy groups.

Specific examples of the C₁ to C₁₂ alkoxyphenoxy group include a methoxyphenoxy group, ethoxyphenoxy group, propyloxyphenoxy group, isopropyloxyphenoxy group, butoxyphenoxy group, isobutoxyphenoxy group, t-butoxyphenoxy group, pentyloxyphenoxy group, hexyloxyphenoxy group, cyclohexyloxyphenoxy group, heptyloxyphenoxy group, octyloxyphenoxy group, 2-ethylhexyloxyphenoxy group, nonyloxyphenoxy group, decyloxyphenoxy group, 3,7-dimethyloctyloxyphenoxy group, lauryloxyphenoxy group and the like.

Specific examples of the C₁ to C₁₂ alkylphenoxy group include a methylphenoxy group, ethylphenoxy group, dimethylphenoxy group, propylphenoxy group, 1,3,5-trimethylphenoxy group, methylethylphenoxy group, isopropylphenoxy group, butylphenoxy group, isobutylphenoxy group, t-butylphenoxy group, pentylphenoxy group, isoamylphenoxy group, hexylphenoxy group, heptylphenoxy group, octylphenoxy group, nonylphenoxy group, decylphenoxy group, dodecylphenoxy group and the like.

The arylthio group optionally has a substituent on an aromatic ring, and the carbon number thereof is usually about from 3 to 60, and specific examples thereof include a phenylthio group, C₁ to C₁₂ alkoxyphenylthio groups, C₁ to C₁₂ alkylphenylthio groups, 1-naphthylthio group, 2-naphthylthio group, pentafluorophenylthio group, pyridylthio group, pyridazinylthio group, pyrimidylthio group, pyrazylthio group, triazylthio group and the like.

The arylalkyl group optionally has a substituent, and the carbon number thereof is usually about from 7 to 60, and specific examples thereof include phenyl C₁ to C₁₂ alkyl groups, C₁ to C₁₂ alkoxyphenyl C₁ to C₁₂ alkyl groups, C₁ to C₁₂ alkylphenyl C₁ to C₁₂ alkyl groups, 1-naphthyl C₁ to C₁₂ alkyl groups, 2-naphthyl C₁ to C₁₂ alkyl groups and the like.

The arylalkoxy group optionally has a substituent, and the carbon number thereof is usually about from 7 to 60, and specific examples thereof include phenyl C₁ to C₁₂ alkoxy groups, C₁ to C₁₂ alkoxyphenyl C₁ to C₁₂ alkoxy groups, C₁ to C₁₂ alkylphenyl C₁ to C₁₂ alkoxy groups, 1-naphthyl C₁ to C₁₂ alkoxy groups, 2-naphthyl C₁ to C₁₂ alkoxy groups and the like.

The arylalkylthio group optionally has a substituent, and the carbon number thereof is usually about from 7 to 60, and specific examples thereof include phenyl C₁ to C₁₂ alkylthio groups, C₁ to C₁₂ alkoxyphenyl C₁ to C₁₂ alkylthio groups, C₁ to C₁₂ alkylphenyl C₁ to C₁₂ alkylthio groups, 1-naphthyl C₁ to C₁₂ alkylthio groups, 2-naphthyl C₁ to C₁₂ alkylthio groups and the like.

The arylalkenyl group has a carbon number of usually about from 8 to 60, and specific examples thereof include phenyl C₂ to C₁₂ alkenyl groups, C₁ to C₁₂ alkoxyphenyl C₂ to C₁₂ alkenyl groups, C₁ to C₁₂ alkylphenyl C₂ to C₁₂ alkenyl groups, 1-naphthyl C₂ to C₁₂ alkenyl groups, 2-naphthyl C₂ to C₁₂ alkenyl groups and the like, and preferable are C₁ to C₁₂ alkoxyphenyl C₂ to C₁₂ alkenyl groups and C₂ to C₁₂ alkylphenyl C₁ to C₁₂ alkenyl groups.

The arylalkynyl group has a carbon number of usually about from 8 to 60, and specific examples thereof include phenyl C₂ to C₁₂ alkynyl groups, C₁ to C₁₂ alkoxyphenyl C₂ to C₁₂ alkynyl groups, C₁ to C₁₂ alkylphenyl C₂ to C₁₂ alkynyl groups, 1-naphthyl C₂ to C₁₂ alkynyl groups, 2-naphthyl C₂ to C₁₂ alkynyl groups and the like, and preferable are C₁ to C₁₂ alkoxyphenyl C₂ to C₁₂ alkynyl groups and C₁ to C₁₂ alkylphenyl C₂ to C₁₂ alkynyl groups.

The substituted amino group includes amino groups substituted with one or two groups selected from alkyl groups, aryl groups, aryl alkyl groups and monovalent heterocyclic groups, and the alkyl group, aryl group, aryl alkyl group or monovalent heterocyclic group optionally has a substituent. The carbon number of the substituted amino group is usually about from 1 to 60 not including the carbon number of the substituent, and preferably the carbon number is 2 to 48.

Specific examples include a methylamino group, dimethylamino group, ethylamino group, diethylamino group, propylamino group, dipropylamino group, isopropylamino group, diisopropylamino group, butylamino group, isobutylamino group, secondary butyl group, t-butylamino group, pentylamino group, hexylamino group, cyclohexylamino group, heptylamino group, octylamino group, 2-ethylhexylamino group, nonylamino group, decylamino group, 3,7-dimethyloctylamino group, laurylamino group, cyclopentylamino group, dicyclopentylamino group, cyclohexylamino group, dicyclohexylamino group, pyrrolidyl group, piperidyl group, ditrifluoromethylamino group, phenylamino group, diphenylamino group, C₁ to C₁₂ alkoxyphenylamino groups, di(C₁ to C₁₂ alkoxyphenyl)amino groups, di(C₁ to C₁₂ alkylphenyl)amino groups, 1-naphthylamino group, 2-naphthylamino group, pentafluorophenylamino group, pyridylamino group, pyridazinylamino group, pyrimidylamino group, pyrazylamino group, triazylamino group, phenyl C₁ to C₁₂ alkylamino groups, C₁ to C₁₂ alkoxyphenyl C₁ to C₁₂ alkylamino groups, C₁ to C₁₂ alkylphenyl C₁ to C₁₂ alkylamino groups, di (C₁ to C₁₂ alkoxyphenyl C₁ to C₁₂ alkyl)amino groups, di(C₁ to C₁₂ alkylphenyl C₁ to C₁₂ alkyl)amino groups, 1-naphthyl C₁ to C₁₂ alkylamino groups, 2-naphthyl C₁ to C₁₂ alkylamino groups and the like.

The substituted silyl group includes silyl groups substituted with one, two or three groups selected from alkyl groups, aryl groups, aryl alkyl groups and monovalent heterocyclic groups. The carbon number of the substituted silyl group is usually about from 1 to 60, preferably 3 to 48. The alkyl group, aryl group, aryl alkyl group or monovalent heterocyclic group optionally has a substituent.

Specific examples include a trimethylsilyl group, triethylsilyl group, tripropylsilyl group, triisopropylsilyl group, dimethylisopropylsilyl group, diethylisopropylsilyl group, t-butyldimethylsilyl group, pentyldimethylsilyl group, hexyldimethylsilyl group, heptyldimethylsilyl group, octyldimethylsilyl group, 2-ethylhexyldimethylsilyl group, nonyldimethylsilyl group, decyldimethylsilyl group, 3,7-dimethyloctyldimethylsilyl group, lauryldimethylsilyl group, phenyl C₁ to C₁₂ alkylsilyl groups, C₁ to C₁₂ alkoxyphenyl C₁ to C₁₂ alkylsilyl groups, C₁ to C₁₂ alkylphenyl C₁ to C₁₂ alkylsilyl groups, 1-naphthyl C₁ to C₁₂ alkylsilyl groups, 2-naphthyl C₁ to C₁₂ alkylsilyl groups, phenyl C₁ to C₁₂ alkyldimethylsilyl groups, triphenylsilyl group, trip-xylylsilyl group, tribenzylsilyl group, diphenylmethylsilyl group, t-butyldiphenylsilyl group, dimethylphenylsilyl group and the like.

Examples of the halogen atom include a fluorine atom, chlorine atom, bromine atom and iodine atom.

The acyl group has a carbon number of usually about from 2 to 20, preferably 2 to 18, and specific examples thereof include an acetyl group, propionyl group, butyryl group, isobutyryl group, pivaloyl group, benzoyl group, trifluoroacetyl group, pentafluorobenzoyl group and the like.

The acyloxy group has a carbon number of usually about from 2 to 20, preferably 2 to 18, and specific examples thereof include an acetoxy group, propionyloxy group, butyryloxy group, isobutyryloxy group, pivaloyloxy group, benzoyloxy group, trifluoroacetyloxy group, pentafluorobenzoyloxy group and the like.

The imine residue includes residues obtained by removing one hydrogen atom from imine compounds (meaning organic compounds having -N=C- in the molecule. Examples thereof include aldimines, ketimines, and compounds obtained by substituting a hydrogen atom on N in these compounds by an alkyl group or the like), and has a carbon number of usually about from 2 to 20, preferably 2 to 18. Specific examples include groups of the following structural formulae, and the like.

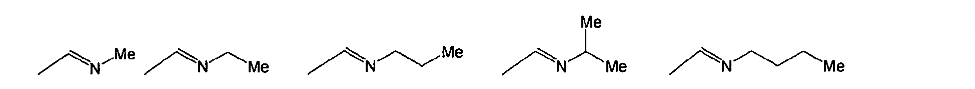

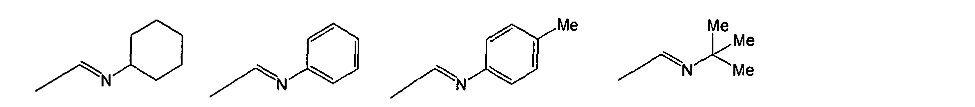

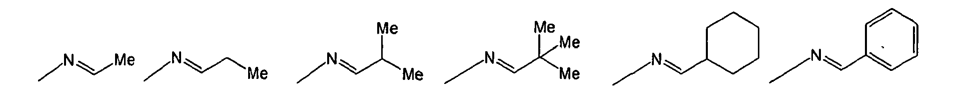

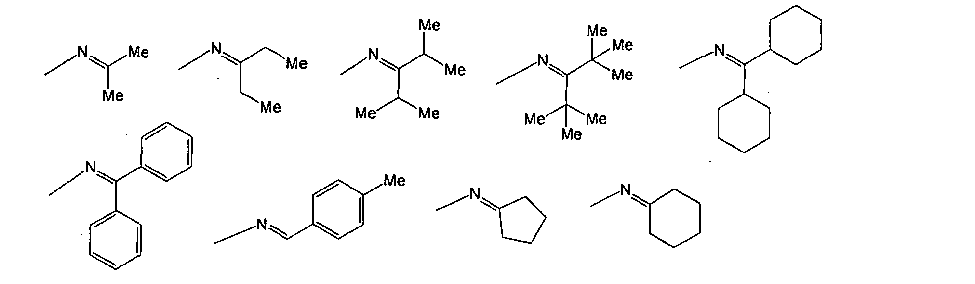

The amide group has a carbon number of usually about from 2 to 20, preferably 2 to 18, and specific examples thereof include a formamide group, acetamide group, propioamide group, butyroamide group, benzamide group, trifluoroacetamide group, pentafluorobenzamide group, diformamide group, diacetamide group, dipropioamide group, dibutyroamide group, dibenzamide group, ditrifluoroacetamide group, dipentafluorobenzamide group and the like.

As the acid imide group, residues obtained by removing from an acid imide a hydrogen atom bonded to its nitrogen atom are mentioned, and the carbon number thereof is about from 4 to 20, and specific examples include the following groups and the like.

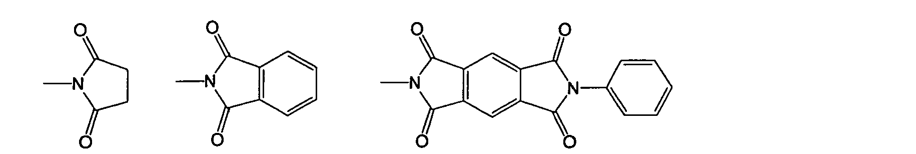

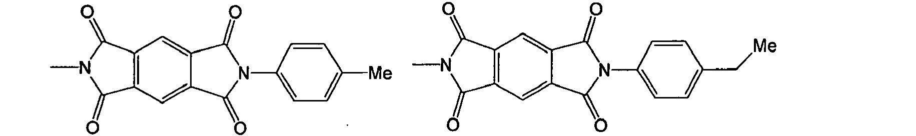

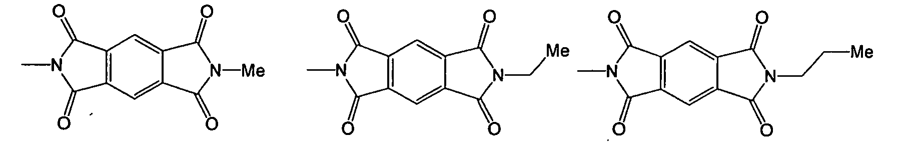

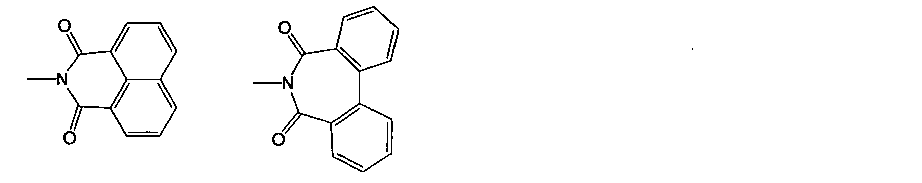

The substituted carboxyl group refers to a carboxyl group substituted with an alkyl group, aryl group, arylalkyl group or monovalent heterocyclic group, and the carbon number thereof is usually about from 2 to 60, preferably 2 to 48, and specific examples thereof include a methoxycarbonyl group, ethoxycarbonyl group, propoxycarbonyl group, isopropoxycarbonyl group, butoxycarbonyl group, isobutoxycarbonyl group, t-butoxycarbonyl group, pentyloxycarbonyl group, hexyloxycarbonyl group, cyclohexyloxycarbonyl group, heptyloxycarbonyl group, octyloxycarbonyl group, 2-ethylhexyloxycarbonyl group, nonyloxycarbonyl group, decyloxycarbonyl group, 3,7-dimethyloctyloxycarbonyl group, dodecyloxycarbonyl group, trifluoromethoxycarbonyl group, pentafluoroethoxycarbonyl group, perfluorobutoxycarbonyl group, perfluorohexyloxycarbonyl group, perfluorooctyloxycarbonyl group, phenoxycarbonyl group, naphthoxycarbonyl group, pyridyloxycarbonyl group, and the like. The alkyl group, aryl group, arylalkyl group or monovalent heterocyclic group optionally has a substituent. The carbon number of the substituted carboxyl group does not include the carbon number of the substituent.

From the standpoint of easiness of synthesis of raw material monomers, repeating units of the following formula (III) are preferable among repeating units of the above-described formula (I). 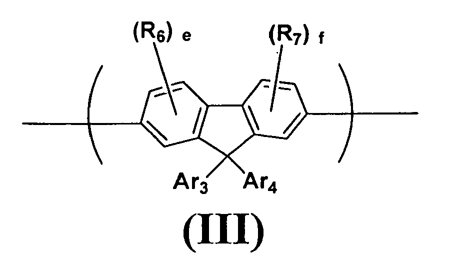 [in the above-described formula (III), Ar₃ and Ar₄ represent each independently an aryl group or monovalent heterocyclic group, R₆ and R₇ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and e and f represent each independently an integer selected from 0 to 3. When there exist a plurality of R₆s and R₇s respectively, they may be the same or different.].

The definitions, specific examples and the like of the alkyl group, alkoxy group, alkylthio group, aryl group, aryloxy group, arylthio group, aryl alkyl group, aryl alkoxy group, aryl alkylthio group, arylalkenyl group, arylalkynyl group, substituted amino group, substituted silyl group, halogen atom, acyl group, acyloxy group, imine residue, amide group, acid imide group, monovalent heterocyclic group and substituted carboxyl group are the same as the definitions, specific examples and the like thereof for R₁, R₂ in the above-described formula (I).

From the standpoint of improvement in the solubility of a polymer compound of the present invention in an organic solvent, R₆ and R₇ in the above-described formula (III) represent each independently preferably an alkyl group, alkoxy group, alkylthio group, aryl group, aryloxy group, arylthio group, aryl alkyl group, aryl alkoxy group, aryl alkylthio group, aryl alkenyl group, aryl alkynyl group or monovalent heterocyclic group, more preferably an alkyl group, alkoxy group, alkylthio group, aryl group, aryloxy group, arylthio group, aryl alkyl group, aryl alkoxy group or aryl alkylthio group, further preferably an alkyl group, alkoxy group, aryl group or aryloxy group, most preferably an alkyl group or aryl group.

From the standpoint of easiness of synthesis of raw materials, Ar₃ and Ar₄ in the above-described formula (III) represent each independently preferably an aryl group, more preferably a phenyl group, 1-naphthyl group, 2-naphthyl group, 1-anthracenyl group, 2-anthracenyl group or 9-anthracenyl group, further preferably a phenyl group, 1-naphthyl group or 2-naphthyl group.

Further, from the standpoint of easiness of synthesis of raw materials, Ar₃ and Ar₄ in the above-described formula (III) represent each independently preferably a group of the following formula (IV). 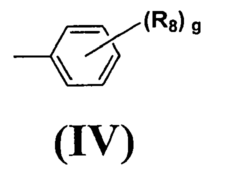 [in the above-described formula (IV), R₈ represents an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and g represents an integer selected from 0 to 5. When there exist a plurality of R₈s, they may be the same or different.].

The definitions, specific examples and the like of the alkyl group, alkoxy group, alkylthio group, aryl group, aryloxy group, arylthio group, aryl alkyl group, aryl alkoxy group, aryl alkylthio group, arylalkenyl group, arylalkynyl group, substituted amino group, substituted silyl group, halogen atom, acyl group, acyloxy group, imine residue, amide group, acid imide group, monovalent heterocyclic group and substituted carboxyl group are the same as the definitions, specific examples and the like thereof for R₁, R₂ in the above-described formula (I).

From the standpoint of improvement in the solubility of a polymer compound of the present invention in an organic solvent, R₈ in the above-described formula (IV) represents preferably an alkyl group, alkoxy group, alkylthio group, aryl group, aryloxy group, arylthio group, aryl alkyl group, aryl alkoxy group, aryl alkylthio group, aryl alkenyl group, aryl alkynyl group or monovalent heterocyclic group, more preferably an alkyl group, alkoxy group, alkylthio group, aryl group, aryloxy group, arylthio group, aryl alkyl group, aryl alkoxy group or aryl alkylthio group, further preferably an alkyl group, alkoxy group, aryl group or aryloxy group.

From the standpoint of easiness of synthesis of raw materials, g in the above-described formula (IV) represents preferably an integer selected from 0 to 3, further preferably an integer selected from 1 to 3.

From the standpoint of easiness of synthesis of raw materials, e and f in the above-described formula (III) represent preferably 0 or 1, most preferably 0.

Specific examples of the repeating unit of the above-described formula (I) include repeating units of the following formulae (I-1) to (I-7).

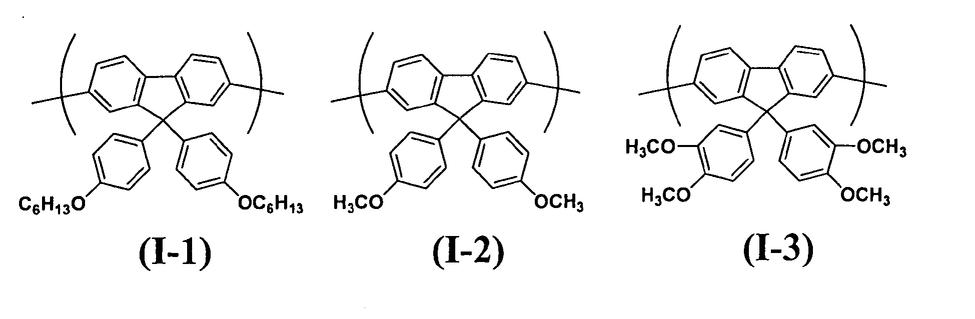

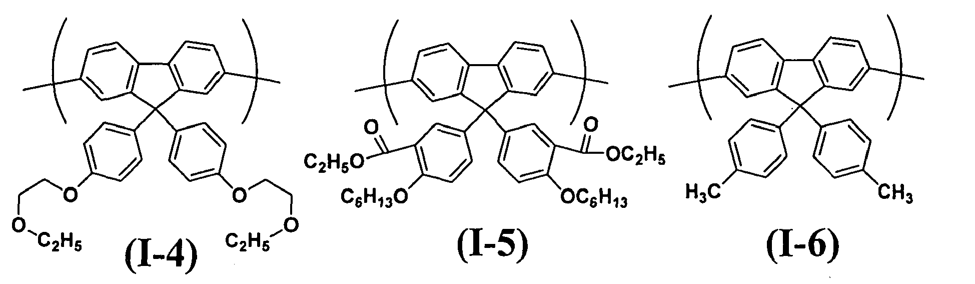

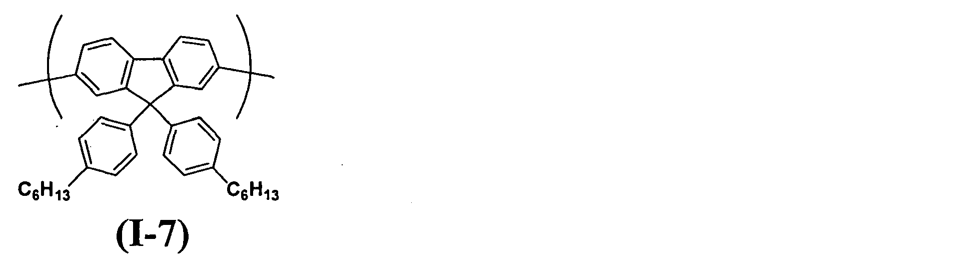

The polymer compound of the present invention has a repeating unit of the following formula (II) in addition to the repeating unit of the above-described formula (I). 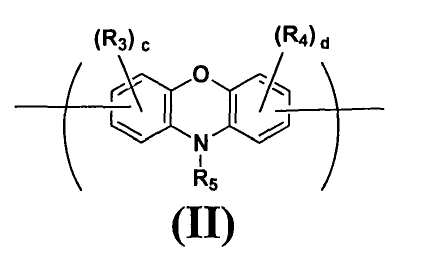 [in the above-described formula (II), R₅ represents an alkyl group, R₃ and R₄ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and c and d represent each independently n integer selected from 0 to 3. When there exist a plurality of R₃s and R₄s respectively, they may be the same or different.

The definitions, specific examples and the like of the alkyl group, alkoxy group, alkylthio group, aryl group, aryloxy group, arylthio group, aryl alkyl group, aryl alkoxy group, aryl alkylthio group, arylalkenyl group, arylalkynyl group, substituted amino group, substituted silyl group, halogen atom, acyl group, acyloxy group, imine residue, amide group, acid imide group, monovalent heterocyclic group and substituted carboxyl group are the same as the definitions, specific examples and the like thereof for R₁, R₂ in the above-described formula (I).

From the standpoint of easiness of synthesis of raw material monomers, repeating units of the following formula (V) are preferable among repeating units of the above-described formula (II). 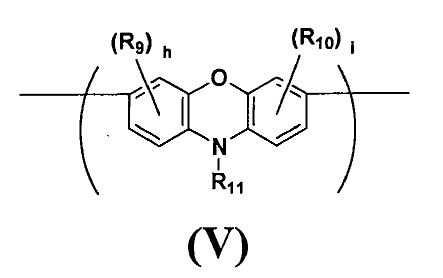 [in the above-described formula (V), R₁₁ represents an alkyl group, R₉ and R₁₀ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and h and i represent each independently an integer selected from 0 to 3. When there exist a plurality of R₉s and R₁₀s respectively, they may be the same or different.].

The definitions, specific examples and the like of the alkyl group, alkoxy group, alkylthio group, aryl group, aryloxy group, arylthio group, aryl alkyl group, aryl alkoxy group, aryl alkylthio group, arylalkenyl group, arylalkynyl group, substituted amino group, substituted silyl group, halogen atom, acyl group, acyloxy group, imine residue, amide group, acid imide group, monovalent heterocyclic group and substituted carboxyl group are the same as the definitions, specific examples and the like thereof for R₁, R₂ in the above-described formula (I).

From the standpoint of improvement in the solubility of a polymer compound of the present invention in an organic solvent, R₉ and R₁₀ in the above-described formula (V) represent each independently preferably an alkyl group, alkoxy group, alkylthio group, aryl group, aryloxy group, arylthio group, arylalkyl group, arylalkoxy group, aryl alkylthio group, arylalkenyl group, arylalkynyl group or monovalent heterocyclic group, more preferably an alkyl group, alkoxy group, alkylthio group, aryl group, aryloxy group, arylthio group, arylalkyl group, arylalkoxy group or arylalkylthio group, further preferably an alkyl group, alkoxy group, aryl group or aryloxy group, most preferably an alkyl group or aryl group.

From the standpoint of easiness of synthesis of raw materials, h and i in the above-described formula (V) represent preferably 0 or 1, more preferably 0.

Specific examples of the repeating unit of the above-described formula (II) include repeating units of the following formulae (II-1) to (II-8).

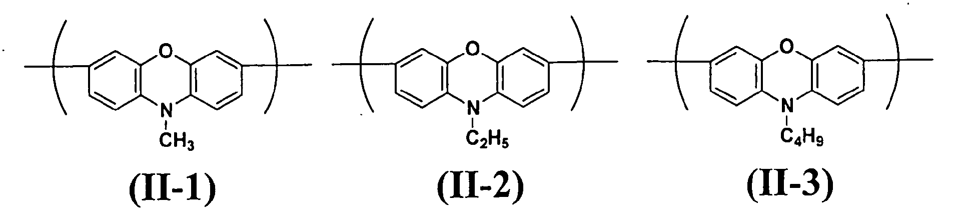

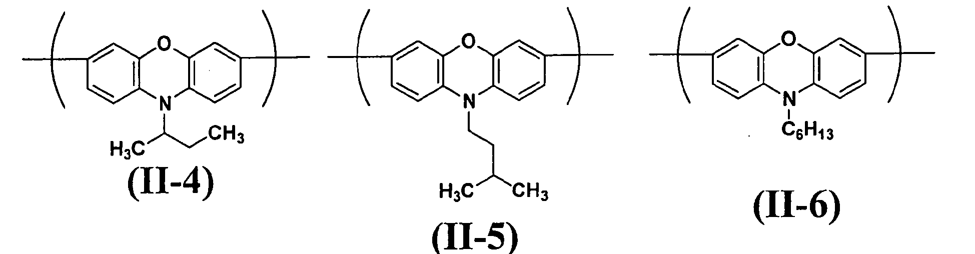

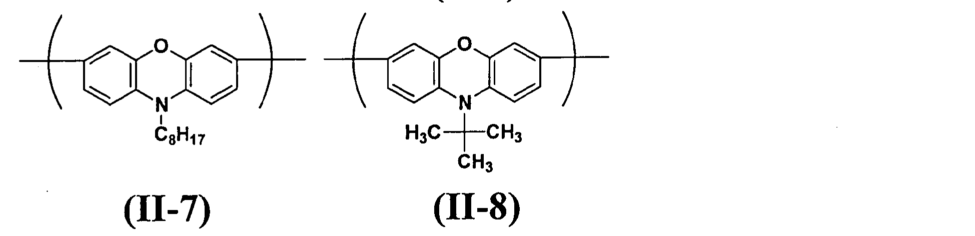

The polymer compound of the present invention may contains two or more repeating units of the above-described formula (I) and two or more repeating units of the above-described formula (II), respectively.

The polymer compound of the present invention is composed of (I) and (II), and preferably composed only of (I) and (II).

The content ratio of (I) and (II) in the polymer compound of the present invention is usually in the range of 0.05 to 100 (=(I)/(II)).

The polymer compound of the present invention include polymer compounds of the following formula (X). 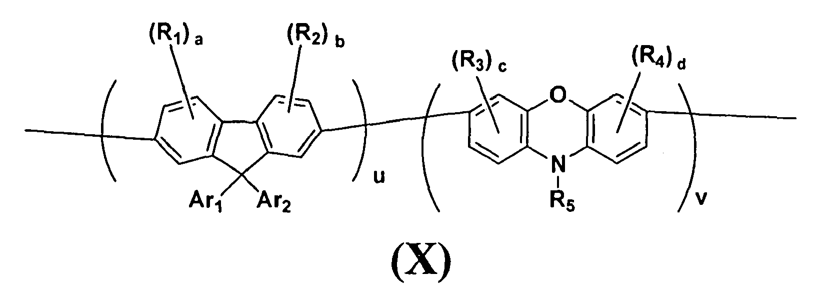 [in the above-described formula (X), the definitions and preferable examples of Ar₁, Ar₂, R₁, R₂, R₃, R₄, R₅, a, b, c and d are the same as described above. u is a value in the range of from 5 to 99, v is a value in the range of from 1 to 95, u+v=100, and u/v is a value in the range of from 0.05 to 99.

The polymer compound of the above-described formula (X) may be any of random copolymer, block copolymer and alternative copolymer.].

The polymer compound of the present invention has a polystyrene-reduced number average molecular weight of preferably 10³ to 10⁸, more preferably 10³ to 10⁷, further preferably 10⁴ to 10⁷ from the standpoint of the life property of a device.

Here, as the number average molecular weight and weight average molecular weight, polystyrene-reduced number average molecular weight and weight average molecular weight were measured by size exclusion chromatography (SEC)(manufactured by Shimadzu Corporation: LC-10 Avp). A polymer to be measured was dissolved in tetrahydrofuran so as to give a concentration of about 0.5 wt%, and the solution was injected in an amount of 50 µL into GPC. Tetrahydrofuran was used as the mobile phase of GPC, and allowed to flow at a flow rate of 0.6 mL/min. As the column, two TSKgel Super HM-H (manufactured by Tosoh Corp.) and one TSKgel Super H2000 (manufactured by Tosoh Corp.) were connected serially. A differential refractive index detector (RID-10A: manufactured by Shimadzu Corp.) was used as a detector.

The copolymer of the present invention may be an alternative, random, block or graft copolymer, or a polymer having an intermediate structure thereof, for example, a random copolymer having a block property. From the standpoint of obtaining a polymer light emitting body showing high quantum yield of fluorescence or phosphorescence, a random copolymer having a block property and a block or graft copolymer are more preferable than a complete random copolymer. Those having branching in the main chain and thus having 3 or more end parts, and dendrimers are also included.

An end group of the polymer compound of the present invention may be protected by a stable group since when a polymerization active group remains intact, there is a possibility of decrease in light emitting property and life when made into a device. A structure containing a conjugation bond continuous with a conjugation structure of the main chain is preferable, and for example, examples include a structure bonding to an aryl group or heterocyclic group via a carbon-carbon bond. Specific examples include substituents described in chemical formula 10 in Japanese Patent Application Laid-Open (JP-A) No. 9-45478, and the like.

Examples of the good solvent for the polymer compound of the present invention include chloroform, methylene chloride, dichloroethane, tetrahydrofuran, toluene, xylene, mesitylene, tetralin, decalin, n-butylbenzene and the like. Depending on the structure and molecular weight of the polymer compound, the polymer compound can be dissolved usually in an amount of 0.1 wt% or more in these solvents.

Next, the method of producing a polymer compound of the present invention will be illustrated.

For example, a compound represented by Y₁-A-Y₂ can be used as one of raw materials, and condensation-polymerized, to produce a polymer compound of the present invention.

In the formula, -A- represents a repeating unit of the above-described formula (I) or (II).

Y₁ and Y₂ represent each independently a condensation-polymerizable substituent.

The substituents (Y₁ and Y₂) participating in condensation polymerization include halogen atoms, alkyl sulfonate groups, aryl sulfonate groups, aryl alkyl sulfonate groups, borate groups, sulfoniummethyl groups, phosphoniummethyl groups, phosphonatemethyl groups, methyl monohalide groups, -B(OH)₂, formyl group, cyano group or vinyl group and the like.

Here, the halogen atom includes a fluorine atom, chlorine atom, bromine atom and iodine atom.

Examples of the alkyl sulfonate group include a methane sulfonate group, ethane sulfonate group, trifluoromethane sulfonate group and the like, examples of the aryl sulfonate group include a benzene sulfonate group, p-toluene sulfonate group and the like, and examples of the aryl alkyl sulfonate group include a benzyl sulfonate group and the like.

Examples of the borate group include groups of the following formulae. 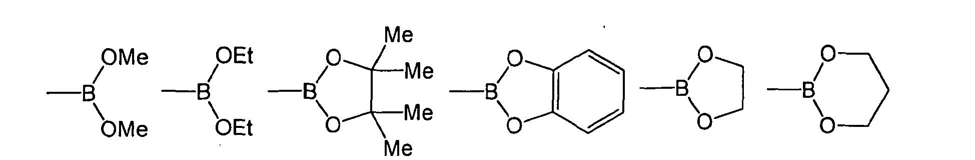 (wherein, Me represents a methyl group, and Et represents an ethyl group)

Examples of the sulfoniummethyl group include groups of the following formulae.

-CH₂S⁺Me₂X⁻, -CH₂S⁺Ph₂X⁻

(wherein, X represents a halogen atom and Ph represents a phenyl group.)

Examples of the phosphoniummethyl group include groups of the following formula.

-CH₂P⁺Ph₃X⁻

(X represents a halogen atom.)

Examples of the phosphonatemethyl group include groups of the following formula.

-CH₂PO(OR')₂

(X represents a halogen atom, R' represents an alkyl group, aryl group or arylalkyl group.)

Examples of the methyl monohalide group include a methyl fluoride group, methyl chloride group, methyl bromide group and methyl iodide group.

A preferable substituent as the substituent participating in condensation polymerization differs depending on the kind of the polymerization reaction, and in the case of use of a 0-valent nickel complex such as, for example, Yamamoto coupling reaction and the like, mentioned are halogen atoms, alkyl sulfonate groups, aryl sulfonate group or aryl alkyl sulfonate groups. In the case of use of a nickel catalyst or palladium catalyst such as Suzuki coupling reaction and the like, mentioned are alkyl sulfonate groups, halogen atoms, borate groups, -B(OH)₂ and the like.

The production of a polymer compound of the present invention can be carried out, specifically, by dissolving a compound having a plurality of substituents participating in condensation polymerization, as a monomer, in an organic solvent if necessary, and using, for example, an alkali and a suitable catalyst, at temperatures of not lower than the melting point and not higher than the boiling point of the organic solvent.

For example, known methods can be used described in "Organic Reactions", vol. 14, p. 270 to 490, John Wiley & Sons, Inc., 1965, "Organic Syntheses", Collective Volume VI, p. 407 to 411, John Wiley & Sons, Inc., 1988, Chem. Rev., vol. 95, p. 2457 (1995), J. Organomet. Chem., vol. 576, p. 147 (1999), Makromol. Chem., Macromol. Symp., vol. 12, p. 229 (1987), and the like.

The polymer compound of the present invention can be produced using a known condensation reaction depending on the substituent participating in condensation polymerization.

For example,examples include a method of polymerization by the Suzuki coupling reaction of the corresponding monomer, a method of polymerization by the Grignard method, a method of polymerization by a Ni(0) complex, a method of polymerization by an oxidizer such as FeCl₃ and the like, a method of electrochemical oxidation polymerization, a method by decomposition of an intermediate polymer having a suitable leaving group, and the like.

Of them, the method of polymerization by the Suzuki coupling reaction, the method of polymerization by the Grignard reaction, and the method of polymerization by a nickel 0-valent complex are preferable since structure control is easier.

Of the production methods of the present invention, preferable are production methods in which substituents participating in condensation polymerization (Y₁ and Y₂) are selected each independently from halogen atoms, alkyl sulfonate groups, aryl sulfonate groups or aryl alkyl sulfonate groups, and condensation polymerization is carried out in the present of a nickel 0-valent complex.

The raw material compounds include dihalogenated compounds, bis(alkyl sulfonate) compounds, bis(aryl sulfonate) compounds, bis(aryl alkyl sulfonate) compounds, halogen-alkyl sulfonate compounds, halogen-aryl sulfonate compounds, halogen-aryl alkyl sulfonate compounds, alkyl sulfonate-aryl sulfonate compounds, alkyl sulfonate-aryl alkyl sulfonate compounds, and aryl sulfonate-aryl alkyl sulfonate compounds.

In this case, there are mentioned methods for producing a polymer compound in which sequence is controlled, by using, for example, a halogen-alkyl sulfonate compound, halogen-aryl sulfonate compound, halogen-aryl alkyl sulfonate compound, alkyl sulfonate-aryl sulfonate compound, alkyl sulfonate-aryl alkyl sulfonate compound, and aryl sulfonate-aryl alkyl sulfonate compound as a raw material compound.

Among the production methods of the present invention, preferable are production methods in which substituents participating in condensation polymerization (Y₁ and Y₂) are selected each independently from halogen atoms, alkyl sulfonate groups, aryl sulfonate groups, aryl alkyl sulfonate groups, boric group, or borate groups, the ratio of the sum (J) of mol numbers of halogen atoms, alkyl sulfonate groups, aryl sulfonate groups and aryl alkyl sulfonate groups to the sum (K) of mol numbers of boric group (-B(OH)₂) and borate groups, in all raw material compounds, is substantially 1 (usually, K/J is in the range of from 0.7 to 1.2), and condensation polymerization is carried out using a nickel catalyst or palladium catalyst.

As specific combinations of raw material compounds, there are mentioned combinations of a dihalogenated compound, bis(alkyl sulfonate) compound, bis(aryl sulfonate) compound or bis(aryl alkyl sufonate) compound with a diboric acid compound or diborate compound.

Further mentioned are a halogen-boric acid compound, halogen-borate compound, alkyl sulfonate-boric acid compound, alkyl sulfonate-borate compound, aryl sulfonate-boric acid compound, aryl sulfonate-borate compound, aryl alkyl sulfonate-boric acid compound, aryl alkyl sulfonate-boric acid compound and aryl alkyl sulfonate-borate compound.

In this case, there are mentioned methods for producing a polymer compound in which sequence is controlled, by using, for example, a halogen-boric acid compound, halogen-borate compound, alkyl sulfonate-boric acid compound, alkyl sulfonate-borate compound, aryl sulfonate-boric acid compound, aryl sulfonate-borate compound, aryl alkyl sulfonate-boric acid compound, aryl alkyl sulfonate-boric acid compound or aryl alkyl sulfonate-borate compound as a raw material compound.

The organic solvent differs depending on the compound and reaction to be used, and for suppressing a side reaction, in general, it is preferable that a solvent to be used is subjected to a sufficient deoxidation treatment and the reaction is progressed under an inert atmosphere. Further, it is preferable to perform a dehydration treatment likewise. However, this is not the case when a reaction in a two-phase system with water such as the Suzuki coupling reaction is conducted.

Examples of the solvent include saturated hydrocarbons such as pentane, hexane, heptane, octane, cyclohexane and the like, unsaturated hydrocarbons such as benzene, toluene, ethylbenzene, xylene and the like, halogenated saturated hydrocarbons such as carbon tetrachloride, chloroform, dichloromethane, chlorobutane, bromobutane, chloropentane, bromopentane, chlorohexane, bromohexane, chlorocyclohexane, bromocyclohexane and the like, halogenated unsaturated hydrocarbons such as chlorobenzene, dichlorobenzene, trichlorobenzene and the like, alcohols such as methanol, ethanol, propanol, isopropanol, butanol, t-butyl alcohol and the like, carboxylic acids such as formic acid, acetic acid, propionic acid and the like, ethers such as dimethyl ether, diethyl ether, methyl-t-butyl ether, tetrahydrofuran, tetrahydropyran, dioxane and the like, amines such as trimethylamine, triethylamine, N,N,N',N'-tetramethylethylenediamine, pyridine and the like, amides such as N,N-dimethylformamide, N,N-dimethylacetamide, N,N-diethylacetamide, N-methylmorpholine oxide, and the like. These solvents may be used singly or in admixture. Of them, ethers are preferable, and tetrahydrofuran and diethyl ether are further preferable.

For reacting, an alkali or suitable catalyst is appropriately added. These may be advantageously selected depending on the reaction to be used. As the alkali or catalyst, those sufficiently dissolved in the solvent used in the reaction are preferable. Examples of the method of mixing an alkali or catalyst include a method in which a solution of an alkali or catalyst is added slowly while stirring the reaction liquid under an inert atmosphere such as argon and nitrogen and the like, or reversely, the reaction liquid is slowly added to a solution of an alkali or catalyst.

When the polymer compound of the present invention is used in a polymer LED and the like, its purity exerts an influence on the performance of a device such as a light emitting property and the like, therefore, it is preferable that a monomer before polymerization is purified by a method such as distillation, sublimation purification, recrystallization and the like before polymerization. Further, it is preferable that, after polymerization, a purification treatment such as re-precipitation purification, fractionation by chromatography, and the like is carried out.

The composition of the present invention is a composition containing a polymer compound of the present invention,
and includes compositions characterized by containing at least one material selected from the group consisting of hole transporting material, electron transporting materials and light emitting materials and at least one polymer compound of the present invention, compositions characterized by containing at least two polymer compounds of the present invention, and the like.

When the composition of the present invention contains a hole transporting material, the proportion of the hole transporting material in the composition is usually from 1 wt% to 80 wt%, preferably 5 wt% to 60 wt%. When the composition of the present invention contains an electron transporting material, the proportion of the electron transporting material in the composition is usually from 1 wt% to 80 wt%, preferably 5 wt% to 60 wt%. When the composition contains a light emitting material, the proportion of the light emitting material in the composition is usually from 1 wt% to 80 wt%, preferably 5 wt% to 60 wt%.

When the composition of the present invention contains at least two polymer compounds of the present invention, mentioned are those containing polymer compounds in which the proportions of a repeating unit of the above-described formula (I) and a repeating unit of the above-described formula (II) constituting the polymer compounds are different.

When the composition of the present invention contains at least two polymer compounds of the present invention, it is preferable that the contents of a repeating unit of the formula (II) are mutually different by 10% or more between two polymer compounds since then the hole transportability of the composition can be controlled easily.

It is preferable that at least one polymer compound constituting the present composition contains a repeating unit of the formula (II) in a proportion of 20% or more, from the standpoint of high hole transportability.

The liquid composition of the present invention is useful for manufacturing of an organic transistor and a light emitting device such as a polymer light emitting device or the like. The liquid composition contains the above-described polymer compound and a solvent. In this specification, "liquid composition" means a composition which is liquid in device production, and typically, one which is liquid at normal pressure (namely, 1 atm) and 25°C. The liquid composition is, in general, referred to as ink, ink composition, solution or the like in some cases.

The liquid composition of the present invention may contain a light emitting material, hole transporting material, electron transporting material, stabilizer, additives for controlling viscosity and/or surface tension, antioxidant and the like, in addition to the above-described polymer compound. These optional components may be used each singly or in combination of two or more.

Examples of the light emitting material which may be contained in the liquid composition of the present invention include light emitting materials such as naphthalene derivatives, anthracene, anthracene derivatives, perylene, perylene derivatives, polymethine coloring matters, xanthene coloring matters, coumarin coloring matters, cyanine coloring matters, metal complexes having a metal complex of 8-hydroxyquinoline as a ligand, metal complexes having a 8-hydroxyquinoline derivative as a ligand, other fluorescent metal complexes, aromatic amines, tetraphenylcyclopentadiene, tetraphenylcyclopentadiene derivatives, tetraphenylcyclobutadiene, tetraphenylcyclobutadiene derivatives, stilbenes, silicon-containing aromatics, oxazoles, furoxans, thiazoles, tetraarylmethanes, thiadiazoles, pyrazoles, metacyclophanes, acetylenes and the like. Specific examples thereof include those described in JP-A Nos. 57-51781, 59-194393 and the like, and known materials.

Examples of the hole transporting material which may be contained in the liquid composition of the present invention include polyvinylcarbazole and derivatives thereof, polysilane and derivatives thereof, polysiloxane derivatives having an aromatic amine on the side chain or main chain, pyrazoline derivatives, arylamine derivatives, stilbene derivatives, triphenyldiamine derivatives, polyaniline and derivatives thereof, polythiophene and derivatives thereof, polypyrrole and derivatives thereof, poly(p-phenylenevinylene) and derivatives thereof, poly(2,5-thienylenevinylene) and derivatives thereof, and the like.

Examples of the electron transporting material which may be contained in the liquid composition of the present invention include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivative, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, and the like.

Examples of the stabilizer which may be contained in the liquid composition of the present invention include phenol antioxidants, phosphorus antioxidants and the like.

As the additives for controlling viscosity and/or surface tension which may be contained in the liquid composition of the present invention, for example, a compound of high molecular weight for increasing viscosity (thickening agent) and a poor solvent, a compound of low molecular weight for decreasing viscosity, a surfactant for decreasing surface tension, and the like may be appropriately combined and used.

As the above-described compound of high molecular weight, those not disturbing light emission and charge transportation may be permissible, and usually, these are soluble in a solvent of the liquid composition. As the compound of high molecular weight, for example, polystyrene of high molecular weight, polymethyl methacrylate of high molecular weight, and the like can be used. The above-described compound of high molecular weight has a polystyrene-reduced number average molecular weight of preferably 500000 or more, more preferably 1000000 or more. Also a poor solvent can be used as a thickening agent.

As the antioxidant which may be contained in the liquid composition of the present invention, those not disturbing light emission and charge transportation may be permissible, and when the composition contains a solvent, these are usually soluble in the solvent. Examples of the antioxidant include phenol antioxidants, phosphorus antioxidants and the like. By use of the antioxidant, preservation stability of the above-described polymer compound and solvent can be improved.

When the liquid composition of the present invention contains a hole transporting material, the proportion of the hole transporting material in the liquid composition is usually from 1 wt% to 80 wt%, preferably 5 wt% to 60 wt%. When the liquid composition of the present invention contains an electron transporting material, the proportion of the electron transporting material in the liquid composition is usually from 1 wt% to 80 wt%, preferably 5 wt% to 60 wt%.

In the case of firm formation using this liquid composition in producing a polymer light emitting device, it may be advantageous to only remove a solvent by drying after application of the liquid composition, and also in the case of mixing of a charge transporting material and a light emitting material, the same means can be applied, that is, this method is extremely advantageous for production. In drying, drying may be effected under heating at about from 50 to 150°C, alternatively, drying may be carried out under reduced pressure of about 10⁻³ Pa.

For film formation using a liquid composition, application methods such as a spin coat method, casting method, micro gravure coat method, gravure coat method, bar coat method, roll coat method, wire bar coat method, dip coat method, slit coat method, cap coat method, capillary coat method, spray coat method, screen printing method, flexo printing method, offset printing method, inkjet print method, nozzle coat method and the like can be used.

The proportion of a solvent in the liquid composition is usually from 1 wt% to 99.9 wt%, preferably 60 wt% to 99.9 wt%, further preferably 90 wt% to 99.8 wt% with respect to the total weight of the liquid composition. Though the viscosity of the liquid composition varies depending on a printing method, the viscosity at 25°C is preferably in a range of from 0.5 to 500 mPa•s, and when a liquid composition passes through a discharge apparatus such as in an inkjet print method and the like, the viscosity at 25°C is preferably in a range of from 0.5 to 20 mPa•s, for preventing clogging and flying curving in discharging.

As the solvent to be contained in the liquid composition, those capable of dissolving or dispersing components other than the solvent in the liquid composition are preferable. Examples of the solvent include chlorine-based solvents such as chloroform, methylene chloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene, trimethylbenzene, mesitylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, methyl benzoate, ethylcellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexane diol and the like and derivatives thereof, alcohol solvents such as methanol, ethanol, propanol, isopropanol, cyclohexanol and the like, sulfoxide solvents such as dimethyl sulfoxide and the like, amide solvents such as N-methyl-2-pyrrolidone, N,N-dimethylformamide, and the like. These solvents may be used singly or in combination of two or more. Among the above-described solvents, one or more organic solvents having a structure containing at least one benzene ring and having a melting point of 0°C or lower and a boiling point of 100°C or higher are preferably contained from the standpoint of viscosity, film formability and the like.

Regarding the kind of the solvent, aromatic hydrocarbon solvents, aliphatic hydrocarbon solvents, ester solvents and ketone solvents are preferable from the standpoint of the solubility of components other than the solvent in a liquid composition into the organic solvent, uniformity in film formation, viscosity property and the like, and preferable are toluene, xylene, ethylbenzene, diethylbenzene, trimethylbenzene, mesitylene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, methylbenzoate, 2-propylcyclohexanone, 2-heptanone, 3-heptanone, 4-heptanone, 2-octanone, 2-nonanone, 2-decanone and dicyclohexyl ketone, and it is more preferable to contain at least one of xylene, anisole, mesitylene, cyclohexylbenzene and bicyclohexylmethyl benzoate.

The number of the solvent to be contained in the liquid composition is preferably 2 or more, more preferably 2 to 3, further preferably 2 from the standpoint of film formability and from the standpoint of a device property and the like.

When two solvents are contained in a liquid composition, one of them may be solid at 25°C. From the standpoint of film formability, it is preferable that one solvent has a boiling point of 180°C or higher and another solvent has a boiling point of lower than 180°C, and it is more preferable that one solvent has a boiling point of 200°C or higher and another solvent has a boiling point of lower than 180°C. From the standpoint of viscosity, it is preferable that 0.2 wt% or more of components excepting solvents from a liquid composition are dissolved at 60°C in solvents, and it is preferable that 0.2 wt% or more of components excepting solvents from a liquid composition are dissolved at 25°C in one of two solvents.

When three solvents are contained in a liquid composition, one or two of them may be solid at 25°C. From the standpoint of film formability, it is preferable that at least one of three solvents has a boiling point of 180°C or higher and at least one solvent has a boiling point of 180°C or lower, and it is more preferable that at least one of three solvents has a boiling point of 200°C or higher and 300°C or lower and at least one solvent has a boiling point of 180°C or lower. From the standpoint of viscosity, it is preferable that 0.2 wt% or more of components excepting solvents from a liquid composition are dissolved at 60°C in two of three solvents, and it is preferable that 0.2 wt% or more of components excepting solvents from a liquid composition are dissolved at 25°C in one of three solvents.

When two or more solvents are contained in a liquid composition, the content of a solvent having highest boiling point is preferably from 40 to 90 wt%, more preferably 50 to 90 wt%, further preferably 65 to 85 wt% with respect to the weight of all solvents contained in the liquid composition, from the standpoint of viscosity and film formability.

### <Application>

The polymer compound of the present invention can be used not only as a light emitting material, but also as a thin film, organic semiconductor material, organic transistor, optical material, solar battery, or an electric conductive material by doping.

The thin film of the present invention will be illustrated. This thin film is obtained by using the above-described polymer compound. Examples of the thin film include light emitting thin films, electric conductive thin films, organic semiconductor thin films and the like.

The light emitting thin film has a quantum yield of light emission of preferably 50% or more, more preferably 60% or more, further preferably 70% or more from the standpoint of the luminance, light emission voltage and the like of a device.

The electric conductive thin film preferably has a surface resistance of 1 KΩ/□ or less. By doping a thin film with a Lewis acid, ionic compound or the like, electric conductivity can be enhanced. The surface resistance is more preferably 100 Ω/□ or less, further preferably 10 Ω/□ or less.

In the organic semiconductor thin film, either larger parameter of electron mobility or hole mobility is preferably 10⁻⁵ cm²/V/s or more, more preferably 10⁻³ cm²/V/s or more, and further preferably 10⁻¹ cm²/V/s or more. Using an organic semiconductor thin film, an organic transistor can be manufactured. Specifically, by forming the organic semiconductor thin film on a Si substrate carrying a gate electrode and an insulation film of SiO₂ and the like formed thereon, and forming a source electrode and a drain electrode with Au and the like, an organic transistor can be obtained.

Next, a polymer electric field effect transistor as one embodiment of organic transistors will be described.

The polymer compound of the present invention can be suitably used as a material of a polymer electric field effect transistor, particularly, as an active layer. Regarding the structure of a polymer electric field effect transistor, it may be usually advantageous that a source electrode and a drain electrode are placed in contact with an active layer made of a polymer, further, a gate electrode is placed sandwiching an insulation layer in contact with the active layer.

The polymer electric field effect transistor is usually formed on a supporting substrate. The material of the supporting substrate is not particularly restricted providing it does not disturb a property as an electric field effect transistor, and glass substrates and flexible film substrates and plastic substrates can also be used.

The polymer electric field effect transistor can be produced by known methods, for example, a method described in JP-A No. 5-110069.

It is very advantageous and preferable for production to use a polymer compound soluble in an organic solvent, in forming an active layer. As a method of film formation from a solution prepared by dissolving an organic solvent-soluble polymer compound in a solvent, application methods such as a spin coat method, casting method, micro gravure coat method, gravure coat method, bar coat method, roll coat method, wire bar coat method, dip coat method, slit coat method, cap coat method, capillary coat method, spray coat method, screen printing method, flexo printing method, offset printing method, inkjet printing method, nozzle coat method and the like can be used.

Preferable is an encapsulated polymer electric field effect transistor obtained by manufacturing a polymer electric field effect transistor, then, encapsulating this. By this, the polymer electric field effect transistor is blocked from atmospheric air, thereby, lowering of properties of the polymer electric field effect transistor can be suppressed.

As the encapsulation method, a method of covering with an ultraviolet (UV) hardening resin, thermosetting resin, or inorganic SiONx film and the like, a method of pasting a glass plate or film with an UV hardening resin, thermosetting resin or the like, and other methods are mentioned. For effectively performing blocking from atmospheric air, it is preferable that processes after manufacturing of a polymer electric field effect transistor until encapsulation are carried out without exposing to atmospheric air (for example, in dried nitrogen atmosphere, vacuum and the like).

Next, the organic solar battery will be described. A solid photoelectric conversion device utilizing a photoelectromotive force effect as an organic photoelectric conversion device as one embodiment of organic solar batteries will be described.

The polymer compound of the present invention can be suitably used as a material of an organic photoelectric conversion device, particularly, as an organic semiconductor layer of a schottky barrier type device utilizing an interface between an organic semiconductor and a metal, or as an organic semiconductor layer of a pn hetero junction type device utilizing an interface between an organic semiconductor and an inorganic semiconductor or between organic semiconductors.

Further, the polymer compound of the present invention can be suitably used as an electron donating polymer or an electron accepting polymer in a bulk hetero junction type device in which the donor-acceptor contact area is increased, or as an electron donating conjugated polymer (dispersion supporting body) of an organic photoelectric conversion device using a high molecular weight-low molecular weight complex system, for example, a bulk hetero junction type organic photoelectric conversion device containing a dispersed fullerene derivative as an electron acceptor.

With respect to the structure of the organic photoelectric conversion device, in the case of for example a pn hetero junction type device, it is advantageous that a p type semiconductor layer is formed on an ohmic electrode, for example, on ITO, further, an n type semiconductor layer is laminated, and an ohmic electrode is provided thereon.

The organic photoelectric conversion device is usually formed on a supporting substrate. The material of the supporting substrate is not particularly restricted providing it does not disturb a property as an organic photoelectric conversion device, and glass substrates and flexible film substrates and plastic substrates can also be used.

The organic photoelectric conversion device can be produced by known methods, for example, a method described in Synth. Met., 102, 982 (1999), and a method described in Science, 270, 1789 (1995).

Next, the polymer light emitting device of the present invention will be described.

The polymer light emitting device of the present invention contains electrodes composed of an anode and a cathode, and a light emitting layer arranged between the electrodes and containing the above-described polymer compound.

The polymer light emitting device of the present invention includes (1) a polymer light emitting device having an electron transporting layer arranged between a cathode and a light emitting layer, (2) a polymer light emitting device having a hole transporting layer arranged between an anode and a light emitting layer, (3) a polymer light emitting device having an electron transporting layer arranged between a cathode and a light emitting layer and having a hole transporting layer arranged between an anode and a light emitting layer; and the like.

More specific examples include the following structures a) to d).
a) anode/light emitting layer/cathode
b) anode/hole transporting layer/light emitting layer/cathode
c) anode/light emitting layer/electron transporting layer/cathode
d) anode/hole transporting layer/light emitting layer/electron transporting layer/cathode
(wherein, / means adjacent lamination of layers, being applicable also in the following descriptions.)

Here, the light emitting layer is a layer having a function of emitting light. The hole transporting layer is a layer having a function of transporting holes, and the electron transporting layer is a layer having a function of transporting electrons. The electron transporting layer and hole transporting layer are collectively called a charge transporting layer. Two or more of the light emitting layers, two or more of the hole transporting layers and two or more of the electron transporting layers may be independently used, respectively.

A hole transporting layer adjacent to a light emitting layer is called an interlayer layer in some cases.

Though the method of film formation of a light emitting layer is not restricted, methods of film formation from a solution are illustrated.

As the method of film formation from a solution, application methods such as a spin coat method, casting method, micro gravure coat method, gravure coat method, bar coat method, roll coat method, wire bar coat method, dip coat method, slit coat method, cap coat method, capillary coat method, spray coat method, screen printing method, flexo printing method, offset printing method, inkjet print method, nozzle coat method and the like can be used.

In the case of film formation from a solution using a polymer compound of the present invention in producing a polymer light emitting device, it may be advantageous to only remove a solvent by drying after application of this solution, and also in the case of mixing of a charge transporting material and a light emitting material, the same means can be applied, that is, this method is extremely advantageous for production.

The thickness of a light emitting layer shows an optimum value varying depending on a material to be used, and may be advantageously regulated so as to give appropriate values of driving voltage and light emission efficiency, and is, for example,from 1 nm to 1 µm, preferably 2 nm to 500 nm, further preferably 5 nm to 200 nm.

In the polymer light emitting device of the present invention, a light emitting material other than the above-described polymer compound may be mixed in a light emitting layer. Further, a light emitting layer containing a light emitting material other than the above-described polymer compound may be laminated to a light emitting layer containing the above-described polymer compound, in the polymer light emitting device of the present invention.

As the light emitting material other than the above-described polymer compound, known materials can be used. As the compounds of low molecular weight, for example, naphthalene derivatives, anthracene and derivatives thereof, perylene and derivatives thereof, coloring matters such as polymethines, xanthenes, coumarins and cyanines, metal complexes of 8-hydroxyquinoline and derivatives thereof, aromatic amines, tetraphenylcyclopentadiene and derivatives thereof, tetraphenylbutadiene and derivatives thereof, and the like can be used. Specifically, known materials such as those described in, for example, JP-A Nos. 57-51781, 59-194393, and the like can be used.

When the polymer light emitting device of the present invention contains a hole transporting layer, examples of the hole transporting material to be used include polyvinylcarbazole and its derivatives, polysilane and its derivatives, polysiloxane derivatives having an aromatic amine on the side chain or main chain, pyrazoline derivatives, arylamine derivatives, stilbene derivatives, triphenyldiamine derivatives, polyaniline and its derivatives, polythiophene and its derivatives, polypyrrole and its derivatives, poly(p-phenylenevinylene) and its derivatives, poly(2,5-thienylenevinylene) and its derivatives, and the like. Specific examples of the hole transporting material include those described in JP-A Nos. 63-70257, 63-175860, 2-135359, 2-135361, 2-209988, 3-37992 and 3-152184, and the like.

Among them, preferable as the hole transporting material used in a hole transporting layer are high molecular weight hole transporting materials such as polyvinylcarbazole and its derivatives, polysilane and its derivatives, polysiloxane derivatives having an aromatic amine compound group on the side chain or main chain, polyaniline and its derivatives, polythiophene and its derivatives, poly(p-phenylenevinylene) and its derivatives, poly(2,5-thienylenevinylene) and its derivatives, and the like, and further preferable are polyvinylcarbazole and its derivatives, polsilane and its derivatives, and polysiloxane derivatives having an aromatic amine on the side chain or main chain. In the case of a low molecular weight hole transporting material, it is preferable that the hole transporting material is dispersed in a polymer binder in use.

Polyvinylcarbazole and its derivative are obtained, for example, from a vinyl monomer by cation polymerization or radical polymerization.

Examples of the polysilane and its derivative include compounds described in Chem. Rev., vol. 89, p. 1359 (1989), GB Patent No. 2300196 publication, and the like. Also as the synthesis method, methods described in them can be used, and particularly, the Kipping method is suitably used.

In the polysiloxane derivative, the siloxane skeleton structure shows little hole transportability, thus, those having a structure of the above-mentioned low molecular weight hole transporting material on the side chain or main chain are suitably used Particularly,examples include those having an aromatic amine showing a hole transportability on the side chain or main chain.

The method of film formation of a hole transporting layer is not particularly restricted, and in the case of use of a low molecular weight hole transporting material,examples include a method of film formation from a mixed solution with a polymer binder. In the case of use of a high molecular weight hole transporting material,examples include a method of film formation from a solution.

The solvent to be used for film formation from a solution is not particularly restricted providing it can dissolve a hole transporting material. Examples of the solvent include chlorine-based solvents such as chloroform, methylene chloride, dichloroethane and the like, ether solvents such as tetrahydrofuran and the like, aromatic hydrocarbon solvents such as toluene, xylene and the like, ketone solvents such as acetone, methyl ethyl ketone and the like, ester solvents such as ethyl acetate, butyl acetate, ethylcellosolve acetate and the like.

As the method of film formation from a solution, there can be used application methods such as a spin coat method, casting method, micro gravure coat method, gravure coat method, bar coat method, roll coat method, wire bar coat method, dip coat method, slit coat method, cap coat method, capillary coat method, spray coat method, screen printing method, flexo printing method, offset printing method, inkjet print method, nozzle coat method and the like.

As the polymer binder to be mixed, those not extremely disturbing charge transportation are preferable, and those showing no strong absorption against visible light are suitably used. Examples of the polymer binder include polycarbonate, polyacrylate, polymethyl acrylate, polymethyl methacrylate, polystyrene, polyvinyl chloride, polysiloxane and the like.

Regarding the thickness of a hole transporting layer, the optimum value varies depending on a material to be used, and it may be advantageously selected so that the driving voltage and light emission efficiency become optimum, and a thickness at least causing no formation of pin holes is necessary, and when the thickness is too large, the driving voltage of a device increases undesirably. Therefore, the thickness of the hole transporting layer is, for example,from 1 nm to 1 µm, preferably 2 nm to 500 nm, further preferably 5 nm to 200 nm.

When the polymer light emitting device of the present invention has an electron transporting layer, known materials can be used as the electron transporting material to be used, and examples include oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, and the like. Specific examples include those described in JP-A Nos. 63-70257, 63-175860, 2-135359, 2-135361, 2-209988, 3-37992 and 3-152184, and the like.

Of them, oxadiazole derivatives, benzoquinone and its derivatives, anthraquinone and its derivatives, metal complexes of 8-hydroxyquinoline and its derivatives, polyquinoline and its derivatives, polyquinoxaline and its derivatives, polyfluorene and its derivatives are preferable, and 2-(4-biphenylyl)-5-(4-t-butylphenyl)-1,3,4-oxadiazole, benzoqinone, anthraquinone, tris(8-quinolinol)aluminum and polyquinoline are further preferable.

The method of film formation an electron transporting layer is not particularly restricted, and in the case of use of an electron transporting material of low molecular weight, examples include a method of vacuum vapor-deposition from powder, methods of film formation from solution or melted conditions, and in the case of use of an electron transporting material of high molecular weight,examples include methods of film formation from solution or melted condition, respectively. In film formation from solution or melted condition, a polymer binder may be used together.

The solvent used for film formation from a solution is not particularly restricted providing it can dissolve an electron transporting material and/or polymer binder. Examples of the solvent include chlorine-based solvents such as chloroform, methylene chloride, dichloroethane and the like, ether solvents such as tetrahydrofuran and the like, aromatic hydrocarbon solvents such as toluene, xylene and the like, ketone solvents such as acetone, methyl ethyl ketone and the like, ester solvents such as ethyl acetate, butyl acetate, ethylcellosolve acetate and the like.

As the method of film formation from solution or melted conditions, application methods such as a spin coat method, casting method, micro gravure coat method, gravure coat method, bar coat method, roll coat method, wire bar coat method, dip coat method, slit coat method, cap coat method, capillary coat method, spray coat method, screen printing method, flexo printing method, offset printing method, inkjet printing method, nozzle coat method and the like can be used.

As the polymer binder to be mixed, those not extremely disturbing charge transportation are preferable, and those showing no strong absorption against visible light are suitably used. Examples of the polymer binder include poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride, polysiloxane and the like.

Regarding the thickness of an electron transporting layer, the optimum value varies depending on a material to be used, and it may be advantageously selected so that the driving voltage and light emission efficiency become optimum, and a thickness at least causing no formation of pin holes is necessary, and when the thickness is too large, the driving voltage of a device increases undesirably. Therefore, the thickness of the electron transporting layer is, for example, from 1 nm to 1 µm, preferably 2 nm to 500 nm, further preferably 5 nm to 200 nm.

Among charge transporting layers arranged adjacent to an electrode, those having a function of improving charge injection efficiency from an electrode and having an effect of lowering the driving voltage of a device are, in particularly, called generally a charge injection layer (hole injection layer, electron injection layer).

Further, for improving close adherence with an electrode or improving charge injection from an electron, the above-mentioned charge injection layer or insulation layer may be arranged adjacent to the electrode, alternatively, for improving close adherence of an interface or preventing mixing and the like, a thin buffer layer may be inserted into an interface of a charge transporting layer and a light emitting layer.

The order and number of layers to be laminated, and thickness of each layer may be appropriately selected in view of light emission efficiency and device life.

In the present invention, as the polymer light emitting device carrying a charge injection layer (electron injection layer, hole injection layer) provided thereon, mentioned are polymer light emitting devices having a charge injection layer arranged adjacent to a cathode and polymer light emitting devices having a charge injection layer provided adjacent to an anode.

For example, the following structures e) to p) are specifically mentioned.
e) anode/charge injection layer/light emitting layer/cathode
f) anode/light emitting layer/charge injection layer/cathode
g) anode/charge injection layer/light emitting layer/charge injection layer/cathode
h) anode/charge injection layer/hole transporting layer/light emitting layer/cathode
i) anode/hole transporting layer/light emitting layer/charge injection layer/cathode
j) anode/charge injection layer/hole transporting layer/light emitting layer/charge injection layer/cathode
k) anode/charge injection layer/light emitting layer/charge transporting layer/cathode
l) anode/light emitting layer/electron transporting layer/charge injection layer/cathode
m) anode/charge injection layer/light emitting layer/electron transporting layer/charge injection layer/cathode
n) anode/charge injection layer/hole transporting layer/light emitting layer/charge transporting layer/cathode
o) anode/hole transporting layer/light emitting layer/electron transporting layer/charge injection layer/cathode
p) anode/charge injection layer/hole transporting layer/light emitting layer/electron transporting layer/charge injection layer/cathode

Specific examples of the charge injection layer include a layer containing an electric conductive polymer, a layer arranged between an anode and a hole transporting layer and containing a material having ionization potential of a value between an anode material and a hole transporting material contained in a hole transporting layer, a layer arranged between a cathode and an electron transporting layer and containing a material having electron affinity of a value between a cathode material and an electron transporting material contained in an electron transporting layer, and the like.

When the above-mentioned charge injection layer contains an electric conductive polymer, the electric conductivity of the electric conductive polymer is preferably 10⁻⁵ S/cm or more and 10³ or less, and for decreasing leak current between light emission picture elements, more preferably 10⁻⁵ S/cm or more and 10² or less, further preferably 10⁻⁵ S/cm or more and 10¹ or less. Usually, for controlling the electric conductivity of the electric conductive polymer to 10⁻⁵ S/cm or more and 10³ or less, the electric conductive polymer is doped with a suitable amount of ions.

As the kind of ions to be doped, an anion is used in a hole injection layer and a cation is used in an electron injection layer. Examples of the anion include a polystyrenesulfonic ion, alkylbenzenesulfonic ion, camphorsulfonic ion and the like, and examples of the cation include a lithium ion, sodium ion, potassium ion, tetrabutylammonium ion and the like.

The thickness of the charge injection layer is, for example,from 1 nm to 100 nm, preferably 2 nm to 50 nm.

The material used in the charge injection layer may be appropriately selected depending on a relation with materials of an electrode and an adjacent layer, and examples include electric conductive polymers such as polyaniline and its derivatives, polythiophene and its derivatives, polypyrrole and its derivatives, polyphenylenevinylene and its derivatives, polythienylenevinylene and its derivatives, polyquinoline and its derivatives, polyquinoxaline and its derivatives, polymers containing an aromatic amine structure on the main chain or side chain, and the like, and metal phthalocyanines (copper phthalocyanine and the like), carbon and the like.

The insulation layer has a function of making charge injection easier. The average thickness of this insulation layer is usually from 0.1 to 20 nm, preferably 0.5 to 10 nm, more preferably 1 to 5 nm. As the material of the insulation layer, metal fluorides, metal oxides, organic insulating materials and the like are mentioned. As the polymer light emitting device carrying an insulation layer provided thereon, there are mentioned polymer light emitting devices in which an insulation layer is arranged adjacent to a cathode, and polymer light emitting devices in which an insulation layer is arranged adjacent to an anode.

Specifically, for example, the following structures q) to ab) are mentioned.
q) anode/insulation layer/light emitting layer/cathode
r) anode/light emitting layer/insulation layer/cathode
s) anode/insulation layer/light emitting layer/insulation layer/cathode
t) anode/insulation layer/hole transporting layer/light emitting layer/cathode
u) anode/hole transporting layer/light emitting layer/insulation layer/cathode
v) anode/insulation layer/hole transporting layer/light emitting layer/insulation layer/cathode
w) anode/insulation layer/light emitting layer/electron transporting layer/cathode
x) anode/light emitting layer/electron transporting layer/insulation layer/cathode
y) anode/insulation layer/light emitting layer/electron transporting layer/insulation layer/cathode
z) anode/insulation layer/hole transporting layer/light emitting layer/electron transporting layer/cathode
aa) anode/hole transporting layer/light emitting layer/electron transporting layer/insulation layer/cathode
ab) anode/insulation layer/hole transporting layer/light emitting layer/electron transporting layer/insulation layer/cathode

The substrate used in forming a polymer light emitting device of the present invention may advantageously be one which does not change in forming an electrode and in forming a layer of an organic substance, and for example,examples include substrates of glass, plastic, polymer film, silicon and the like. In the case of an opaque substrate, it is preferable that the opposite electrode is transparent or semi-transparent.

In the present invention, it is usually preferable that at least one of electrodes composed of an anode and cathode is transparent or semi-transparent, and a cathode is transparent or semi-transparent.

As the material of the anode, an electric conductive metal oxide film, semi-transparent metal thin film and the like are used. Specifically, films (NESA and the like) formed using electric conductive glass composed of indium oxide, zinc oxide, tin oxide, and composite thereof: indium•tin•oxide (ITO), indium•zinc•oxide and the like, and gold, platinum, silver, copper and the like are used, and ITO, indium•zinc•oxide, tin oxide are preferable. As the manufacturing method, a vacuum vapor-deposition method, sputtering method, ion plating method, plating method and the like are mentioned. As the anode, organic transparent electric conductive films made of polyaniline and its derivatives, polythiophene and its derivatives, and the like may be used.

The thickness of an anode can be appropriately selected in view of light transmission and electric conductivity, and it is, for example, from 10 nm to 10 µm, preferably 20 nm to 1 µm, further preferably 50 nm to 500 nm.

For making electric charge injection easier, a layer made of a phthalocyanine derivative, electric conductive polymer, carbon and the like, or a layer made of a metal oxide, metal fluoride, organic insulation material and the like, may be provided on an anode.

As the material of a cathode, materials of small work function are preferable. For example, metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium and the like, alloys made of two or more of them, or alloys made of at least one of them and at least one of gold, silver, platinum, copper, manganese, titanium, cobalt, nickel, tungsten and tin, and graphite or graphite intercalation compounds and the like are used. Examples of the alloy include magnesium-silver alloy, magnesium-indium alloy, magnesium-aluminum alloy, indium-silver alloy, lithium-aluminum alloy, lithium-magnesium alloy, lithium-indium alloy, calcium-aluminum alloy and the like. The cathode may take a laminated structure having two or more layers.

The thickness of a cathode can be appropriately selected in view of electric conductivity and durability, and it is, for example,from 10 nm to 10 µm, preferably 20 nm to 1 µm, further preferably 50 nm to 500 nm.

As the cathode manufacturing method, a vacuum vapor-deposition method, sputtering method, lamination method of thermally press-binding a metal thin film, and the like are used. A layer made of an electric conductive polymer, or a layer made of a metal oxide, metal fluoride, organic insulation material and the like, may be provided between a cathode and an organic substance layer, and after manufacturing a cathode, a protective layer for protecting the polymer light emitting device may be installed. For use of the polymer light emitting device stably for a long period of time, it is preferable to install a protective layer and/or protective cover, for protecting a device from outside.

As the protective layer, resins, metal oxides, metal fluorides, metal borides and the like can be used. As the protective cover, a glass plate, and a plastic plate having a surface which has been subjected to low water permeation treatment, and the like can be used, and a method in which the cover is pasted to a device substrate with a thermosetting resin or photo-curing resin to attain sealing is suitably used. When a space is kept using a spacer, blemishing of a device can be prevented easily. If an inert gas such as nitrogen, argon and the like is filled in this space, oxidation of a cathode can be prevented, further, by placing a drying agent such as barium oxide and the like in this space, it becomes easier to suppress moisture adsorbed in a production process from imparting damage to the device. It is preferable to adopt one strategy among these methods.

The polymer light emitting device of the present invention can be used for a sheet light source, and displays such as a segment display, dot matrix display, liquid crystal display (for example, back light and the like).

For obtaining light emission in the form of sheet using a polymer light emitting device of the present invention, it may be advantages to place a sheet anode and a sheet cathode so as to overlap. For obtaining light emission in the form of pattern, there are a method in which a mask having a window in the form of pattern is placed on the surface of the above-mentioned sheet light emitting device, a method in which an organic substance layer in non-light emitting parts is formed with extremely large thickness to give substantially no light emission, a method in which either anode or cathode, or both electrodes are formed in the form pattern. By forming a pattern by any of these methods, and placing several electrodes so that on/off is independently possible, a display of segment type is obtained which can display digits, letters, simple marks and the like. Further, for providing a dot matrix device, it may be permissible that both an anode and a cathode are formed in the form of stripe, and placed so as to cross. By using a method in which several polymer compounds showing different emission colors are painted separately or a method in which a color filter or a fluorescence conversion filter is used, partial color display and multi-color display are made possible. In the case of a dot matrix device, passive driving is also possible, and active driving may be carried out in combination with TFT and the like. These displays can be used as a display of a computer, television, portable terminal, cellular telephone, car navigation, view finder of video camera, and the like.

Further, the above-mentioned sheet light emitting device is of self emitting and thin type, and can be suitably used as a sheet light source for back light of a liquid crystal display, or as a sheet light source for illumination. As the illumination light source, for example, emission colors such as white light emission, red light emission, green light emission, blue light emission and the like are mentioned. If a flexible substrate is used, it can also be used as a curved light source or display.

Examples will be shown below for illustrating the present invention further in detail, but the present invention is not limited to them.

### (Synthesis Example 1)

### Synthesis of N-octylphenoxazine

Under an inert atmosphere, phenoxazine (10.0 g), sodium hydroxide (21.9 g), tetraethylammonium bromide (0.37 g) and dimethyl sulfoxide (34 mL) were mixed, and the mixture was heated up to 80°C, then, 18 mL of water was added and 1-bromooctane (12.9 g) was dropped over a period of 50 minutes. Then, the mixture was heated up to 90°C and stirred for 1 hour, then, cooled down to room temperature. Then, the deposited solid was dissolved in 160 mL of toluene, and washed with water (100 mL) twice, washed with 1 N hydrochloric acid (100 mL) once, and washed with water (100 mL) three times, and allowed to pass through a silica gel column, and subjected to concentration under reduced pressure and drying in vacuo, to obtain 16.0 g of intended N-octylphenoxazine (purity: 99.4%).
¹H-NMR (299.4 MHz, CDCl₃); δ 0.89 (t, 3H), 1.15-1.47 (m, 10H), 1.65 (br, 2H), 3.45 (br, 2H), 6.31-6.88 (br, 8H).
LC-MS (APPI-MS (posi)): 296 [M+H]⁺

### (Synthesis Example 2)

### Synthesis of 3,7-dibromo-N-octylphenoxazine

Under an inert atmosphere, a solution composed of 1,3-dibromo-5,5-dimethylhydantoin (15.1 g) and N,N-dimethylformamide (15.8 mL) was dropped at room temperature over a period of 30 minutes into a solution prepared by adding dichloromethane (55 mL) to N-octylphenoxazine (15.0 g), and the mixture was stirred for 1 hour, then, stirred at room temperature for 6 hours. The resultant precipitate was filtrated and washed with methanol, then, dried under reduced pressure, to obtain 16.6 g of intended 3,7-dibromo-N-octylphenoxazine (purity: 99.7%).
¹H-NMR (299.4 MHz, CDCl₃); δ 0.89 (t, 3H), 1.18-1.46 (m, 10H), 1.59 (br, 2H), 3.38 (br, 2H), 6.29 (d, 2H), 6.73 (s, 2H), 6.88 (d, 2H).
LC-MS (APPI-MS (posi)): 452 [M+H]⁺

### (Synthesis Example 3)

### Synthesis of polymer compound <P-1>

Under an inert atmosphere, 2,7-bis(1,3,2-dioxaborolan-2-yl)-9,9-dioctylfluorene (1.37 g), 2,7-dibromo-9,9-dioctylfluorene (1.22 g), 3,7-dibromo-N-octylphenoxazine (0.18 g), palladium acetate (0.5 mg), tri(2-methylphenyl)phosphine (4.7 mg), Aliquat 336 (0.24 g, manufactured by Aldrich) and toluene (22 mL) were mixed, and the mixture was heated up to 105°C. Into this reaction solution, a 2M Na₂CO₃ aqueous solution (3.6 mL) was dropped, and the mixture was refluxed for 2.5 hours. After the reaction, phenylboronic acid (26.0 mg) was added, and the mixture was further refluxed. Then, a sodium diethyldithiacarbamate aqueous solution was added and the mixture was stirred at 80°C for 2 hours. After cooling, the mixture was washed with water (25 mL) three times, with a 3% acetic acid aqueous solution (25 mL) three times and with water (25 mL) three times, and allowed to pass through an alumina column and silica gel column for purification. The resultant toluene solution was dropped into methanol (800 mL), and the mixture was stirred for 1 hour, then, the resultant solid was filtrated and dried. The resultant polymer compound <P-1> had a yield of 1.86 g.

The polymer compound <P-1> had a polystyrene-reduced number average molecular weight of 9.1×10⁴ and a polystyrene-reduced weight average molecular weight of 2.1×10⁵.

### (Example 1)

### Synthesis of polymer compound <P-2>

Under an inert atmosphere, 2,7-bis(4,4,5,5-tetramethyl-1,3,2-dioxaborolan-2-yl)-9,9-bis(4-hexyloxyphenyl)fluorene (1.54 g), 2,7-dibromo-9,9-bis(4-hexyloxyphenyl)fluorene (1.15 g), 3,7-dibromo-N-octylphenoxazine (0.14 g), palladium acetate (0.7 mg), tri(2-methylphenyl)phosphine (8.7 mg), Aliquat 336 (0.28 g, manufactured by Aldrich) and toluene (23 mL) were mixed, and the mixture was heated up to 105°C. Into this reaction solution, a 2M Na₂CO₃ aqueous solution (3.9 mL) was dropped and the mixture was refluxed for 4 hours. After the reaction, phenylboronic acid (34.3 mg) was added and the mixture was further refluxed for 1.5 hours. Then, a sodium diethyldithiacarbamate aqueous solution was added and stirred at 80°C for 2.5 hours. After cooling, the mixture was washed with water (30 mL) three times, with a 3% acetic acid aqueous solution (30 mL) three times and with water (30 mL) three times, and allowed to pass through an alumina column and silica gel column for purification. The resultant toluene solution was dropped into methanol (800 mL) and the mixture was stirred for 3 hours, then, the resultant solid was filtrated and dried. The resultant polymer compound <P-2> had a yield of 1.83 g.

The polymer compound <P-2> had a polystyrene-reduced number average molecular weight of 7.8×10⁴ and a polystyrene-reduced weight average molecular weight of 2.0×10⁵.

2,7-bis(4,4,5,5-tetramethyl-1,3,2-dioxaborolan-2-yl)-9,9-bis(4-hexyloxy-phenyl)fluorene and 2,7-dibromo-9,9-bis(4-hexyloxy-phenyl)fluorene were synthesized by a method described in WO 2003/095586.

### [Measurement of glass transition temperature of polymer compound <P-2>]

The glass transition temperature was measured by DSC (DSC2920, manufactured by TA Instruments). A sample was kept at 200°C for 5 minutes, then, quenched to -50°C and kept for 30 minutes. After the temperature was raised up to 30°C, the measurement was carried out at a temperature rising rate of 5°C per minute until 300°C.

The resultant polymer compound <P-2> had a glass transition temperature of as high as 191°C, and was excellent in heat resistance.

### [Assembling and evaluation of electroluminescence (EL) device]

### Preparation of polymer compound <P-3> solution

A polymer compound <P-3> synthesized by a method described in WO 2002/045185 was dissolved in xylene to prepare a xylene solution having a polymer concentration of 0.5 w%.

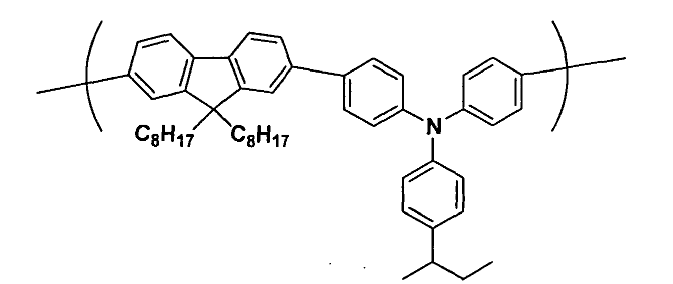

### Preparation of polymer compound <P-2> solution

The polymer compound <P-2> obtained above was dissolved in xylene to prepare a xylene solution having a polymer concentration of 1.2 wt%.

### Assembling of EL device

On a glass substrate carrying thereon an ITO film with a thickness of 150 nm formed by a sputtering method, a liquid obtained by filtrating a suspension of poly(3,4)ethylenedioxythiophene/polystyrenesulfonic acid (BaytronP AI4083, manufactured by Bayer) through a 0.2 µm membrane filter was spin-coated to form a thin film with a thickness of 70 nm which was then dried on a hot plate at 200°C for 10 minutes. Next, the xylene solution of the polymer compound <P-3> obtained above was spin-coated at a revolution of 3000 rpm to form a film which was then dried on a hot plate at 200°C for 15 minutes. After film formation, the thickness was about 10 nm. Further, the xylene solution of the polymer compound <P-2> obtained above was spin-coated at a revolution of 1200 rpm to form a film. After film formation, the thickness was about 80 nm. Further, this was dried under reduced pressure at 80°C for 1 hour, then, as cathode, barium was vapor-deposited with a thickness of about 5 nm, then, aluminum was vapor-deposited with a thickness of about 100 nm, assembling an EL device. After the degree of vacuum reached 1×10⁻⁴ Pa or lower, metal vapor deposition was initiated.

### Performance of EL device

By applying voltage to the resultant device, EL light emission showing a peak at 480 nm was obtained from this device. The maximum light emission efficiency was as high as 11.9 cd/A.

### (Comparative Example 1)

### [Measurement of glass transition temperature of polymer compound <P-1>]

The glass transition temperature was measured by the same manner as for the polymer compound <P-2>.

The resultant polymer compound <P-1> had a glass transition temperature of 76°C.

### [Assembling and evaluation of electroluminescence (EL) device]

### Preparation of polymer compound <P-1> solution

The polymer compound <P-1> obtained above was dissolved in xylene to prepare a xylene solution having a polymer concentration of 1.2 w%.

### Assembling of EL device

On a glass substrate carrying thereon an ITO film with a thickness of 150 nm formed by a sputtering method, a liquid obtained by filtrating a suspension of poly(3,4)ethylenedioxythiophene/polystyrenesulfonic acid (BaytronP AI4083, manufactured by Bayer) through a 0.2 µm membrane filter was spin-coated to form a thin film with a thickness of 70 nm which was then dried on a hot plate at 200°C for 10 minutes. Next, the xylene solution of the polymer compound <P-3> obtained above was spin-coated at a revolution of 3000 rpm to form a film which was then dried on a hot plate at 200°C for 15 minutes. After film formation, the thickness was about 10 nm. Further, the xylene solution of the polymer compound <P-1> obtained above was spin-coated at a revolution of 1200 rpm to form a film. After film formation, the thickness was about 107 nm. Further, this was dried under reduced pressure at 80°C for 1 hour, then, as cathode, barium was vapor-deposited with a thickness of about 5 nm, then, aluminum was vapor-deposited with a thickness of about 100 nm, assembling an EL device. After the degree of vacuum reached 1×10⁻⁴ Pa or lower, metal vapor deposition was initiated.

### Performance of EL device

By applying voltage to the resultant device, EL light emission showing a peak at 470 nm was obtained from this device. The maximum light emission efficiency was 5.19 cd/A.

### INDUSTRIAL APPLICABILITY

The polymer compound of the present invention is excellent in heat resistance and light emission efficiency. Therefore, a polymer LED containing a polymer compound of the present invention can be used for curved or flat light sources as back light or illumination of liquid crystal displays, and, for segment type displays, dot matrix flat panel displays and the like.

## Claims

1. A polymer compound comprising a repeating unit of the following formula (I) and a repeating unit of the following formula (II): 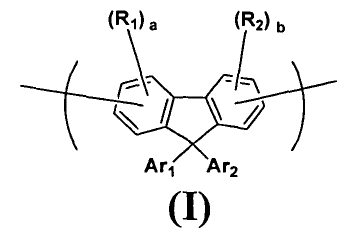 [in the above-described formula (I), Ar₁ and Ar₂ represent each independently an aryl group or monovalent heterocyclic group, R₁ and R₂ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and a and b represent each independently an integer selected from 0 to 3. When there exist a plurality of R₁s and R₂s respectively, they may be the same or different.] 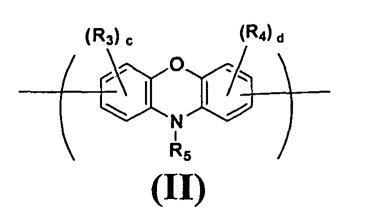 [in the above-described formula (II), R₅ represents an alkyl group, R₃ and R₄ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and c and d represent each independently an integer selected from 0 to 3. When there exist a plurality of R₃s and R₄s respectively, they may be the same or different.].

2. The polymer compound according to Claim 1, wherein the repeating unit of the above-described formula (I) is a repeating unit of the following formula (III): 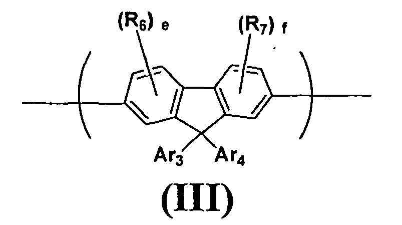 [in the above-described formula (III), Ar₃ and Ar₄ represent each independently an aryl group or monovalent heterocyclic group, R₆ and R₇ represent each independently an alkyl group, alkoxy group, alkylthio group, aryl group, aryloxy group, arylthio group, arylalkyl group, arylalkoxy group, aryl alkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and e and f represent each independently an integer selected from 0 to 3. When there exist a plurality of R₆s and R₇s respectively, they may be the same or different.].

3. The polymer compound according to Claim 2, wherein in the above-described formula (III), Ar₃ and Ar₄ represent each independently a group of the following formula (IV): 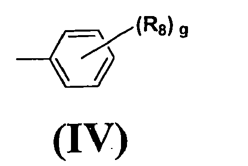 [in the above-described formula (IV), R₈ represents an alkyl group, alkoxy group, alkylthio group, aryl group, aryloxy group, arylthio group, arylalkyl group, aryl alkoxy group, aryl alkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and g represents an integer selected from 0 to 5. When there exist a plurality of R₈s, they may be the same or different.].

4. The polymer compound according to Claim 2 or 3, wherein in the above-described formula (III), e and f represent 0.

5. The polymer compound according to any one of Claims 1 to 4, wherein the repeating unit of the above-described formula (II) is a repeating unit of the following formula (V): 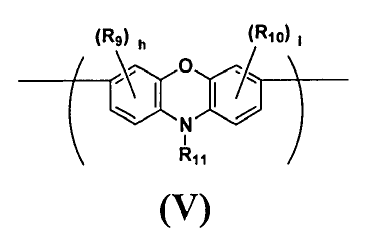 [in the above-described formula (V), R₁₁ represents an alkyl group, R₉ and R₁₀ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, monovalent heterocyclic group, carboxyl group, substituted carboxyl group, cyano group or nitro group, and h and i represent each independently an integer selected from 0 to 3. When there exist a plurality of R₉s and R₁₀s respectively, they may be the same or different.].

6. The polymer compound according to Claim 5, wherein in the above-described formula (V), h and i represent 0.

7. The polymer compound according to any one of Claims 1 to 6, wherein the polystyrene-reduced number average molecular weight thereof is 10³ to 10⁸.

8. A composition comprising at least one material selected from the group consisting of hole transporting materials, electron transporting materials and light emitting materials, and at least one of the polymer compounds as described in any one of Claims 1 to 7.

9. A composition comprising at least two of the polymer compounds as described in any one of Claims 1 to 7.

10. A polymer light emitting device having electrodes composed of an anode and a cathode, and a light emitting layer disposed between the electrodes and containing the polymer compound as described in any one of Claims 1 to 7 or the composition as described in Claim 8 or 9.

11. A sheet light source comprising the polymer light emitting device as described in Claim 10.

12. A display comprising the polymer light emitting device as described in Claim 10.

13. A liquid composition comprising the polymer compound as described in any one of Claims 1 to 7 and a solvent.

14. A liquid composition comprising the composition as described in Claim 8 or 9 and a solvent.

15. A thin film comprising the polymer compound as described in any one of Claims 1 to 7 or the composition as described in Claim 8 or 9.

16. An organic transistor comprising the polymer compound as described in any one of Claims 1 to 7 or the composition as described in Claim 8 or 9.

17. A solar battery comprising the polymer compound as described in any one of Claims 1 to 7 or the composition as described in Claim 8 or 9.
